(19) Europäisches Patentamt
European Patent Office
Office européen des brevets

(11) **EP 3 709 040 B1**

(12) **EUROPÄISCHE PATENTSCHRIFT**

(45) Veröffentlichungstag und Bekanntmachung des Hinweises auf die Patenterteilung:
**30.04.2025 Patentblatt 2025/18**

(21) Anmeldenummer: **19162536.7**

(22) Anmeldetag: **13.03.2019**

(51) Internationale Patentklassifikation (IPC):
**G01R 33/24** (2006.01) **G01R 33/56** (2006.01)
**G01R 33/565** (2006.01)

(52) Gemeinsame Patentklassifikation (CPC):
**G01R 33/243; G01R 33/5608;** G01R 33/56518;
G01R 33/56563; G01R 33/56572

(54) **VERFAHREN ZUM BETRIEB EINER MAGNETFELDKAMERA**

METHOD FOR OPERATING A MAGNETIC FIELD CAMERA

PROCÉDÉ DE FONCTIONNEMENT D'UNE CAMÉRA À CHAMP MAGNÉTIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**16.09.2020 Patentblatt 2020/38**

(73) Patentinhaber: **Siemens Healthineers AG**
**91301 Forchheim (DE)**

(72) Erfinder:
• **Vester, Markus**
**90471 Nürnberg (DE)**
• **Kannengießer, Stephan**
**42113 Wuppertal (DE)**
• **Popescu, Stefan**
**91056 Erlangen (DE)**
• **Rehner, Robert**
**91077 Neunkirchen am Brand (DE)**
• **Ruyters, Gudrun**
**91058 Erlangen (DE)**

(74) Vertreter: **Siemens Healthineers**
**Patent Attorneys**
**Postfach 22 16 34**
**80506 München (DE)**

(56) Entgegenhaltungen:
EP-A1- 1 582 886    EP-A1- 2 515 132
WO-A1-2018/069050

• YING-HUA CHU ET AL: "Decoupled dynamic magnetic field measurements improves diffusion-weighted magnetic resonance images", SCIENTIFIC REPORTS, vol. 7, no. 1, 14 September 2017 (2017-09-14), XP055615098, DOI: 10.1038/s41598-017-11138-8
• YING-HUA CHU ET AL.: "Accurate dynamic magnetic field monitoring and diffusion-weighted image reconstruction using uncorrelated local field measurements", PROCEEDINGS OF THE INTERNATIONAL SOCIETY FOR MAGNETIC RESONANCE IN MEDICINE, ISMRM, 25TH ANNUAL MEETING AND EXHIBITION, HONOLULU, HI, USA, 22 APRIL - 27 APRIL 2017, no. 3915, 7 April 2017 (2017-04-07), XP040691483
• WEBB A G ED - KAY LEWIS ET AL: "Radiofrequency microcoils for magnetic resonance imaging and spectroscopy", JOURNAL OF MAGNETIC RESONANCE, ACADEMIC PRESS, ORLANDO, FL, US, vol. 229, 26 October 2012 (2012-10-26), pages 55 - 66, XP028996793, ISSN: 1090-7807, DOI: 10.1016/J.JMR.2012.10.004
• JOEL A. TANG ET AL: "Practical aspects of liquid-state NMR with inductively coupled solenoid coils", MAGNETIC RESONANCE IN CHEMISTRY., vol. 48, no. 10, 1 October 2010 (2010-10-01), GB, pages 763 - 770, XP055423151, ISSN: 0749-1581, DOI: 10.1002/mrc.2651

**Beschreibung**

Die Erfindung betrifft ein Verfahren zum Messen einer magnetischen Feldverteilung in einem auszumessenden Raumvolumen mit einem Magnetresonanztomographen und einer Feldkamera zum Erfassen einer Magnetfeldverteilung mittels einer Magnetresonanzmessung mit einer Mehrzahl an über ein Raumvolumen verteilten Proben gemäß Anspruch 1.

Magnetresonanztomographen sind bildgebende Vorrichtungen, die zur Abbildung eines Untersuchungsobjektes Kernspins des Untersuchungsobjektes mit einem starken äußeren Magnetfeld ausrichten und durch ein magnetisches Wechselfeld zur Präzession um diese Ausrichtung anregen. Die Präzession bzw. Rückkehr der Spins aus diesem angeregten in einen Zustand mit geringerer Energie wiederum erzeugt als Antwort ein magnetisches Wechselfeld, das über Antennen empfangen wird.

Mit Hilfe von magnetischen Gradientenfeldern wird den Signalen eine Ortskodierung aufgeprägt, die nachfolgend eine Zuordnung von dem empfangenen Signal zu einem Volumenelement ermöglicht. Das empfangene Signal wird dann ausgewertet und eine dreidimensionale bildgebende Darstellung des Untersuchungsobjektes bereitgestellt.

Die Qualität der erzeugten Bilder ist dabei stark sowohl von der Homogenität des statischen Magnetfeldes als auch der Linearität der zur Ortskodierung genutzten Gradientenfelder abhängig. Diese werden auch durch dynamische Effekte wie Wirbelströme beeinflusst, die durch schnell wechselnde Gradientenfelder verursacht werden. Vorrichtungen zum räumlichen erfassen der Magnetfelder werden auch als Feldkamera bezeichnet.

Aus der Patentschrift DE 10 2014 213 413 ist beispielsweise ein Verfahren und eine Vorrichtung zur Messung eines Magnetfelds in einem Magnetresonanztomographiegerät mit mindestens einer Feldsonde bekannt, an die mindestens ein erzeugtes Löschsignal zum Reduzieren einer Residualmagnetisierung in der mindestens einen Feldsonde (FS) anlegbar ist.

Aus dem Dokument YING-HUA CHU ET AL: "Decoupled dynamic magnetic field measurements improves diffusion-weighted magnetic resonance images" (SCIENTIFIC REPORTS, Bd. 7, Nr. 1, 14. September 2017 (2017-09-14), XP055615098, DOI: 10.1038/s41598-017-11138-8) sind Feld-Proben mit lokalisierten NMR-aktiven Proben darin bekannt. Sie sind geeignet, Magnetfelder zu überwachen. Um Messfehler durch Kopplung von Proben zu reduzieren, wird vorgeschlagen eine asymmetrische Matrix mit Kopplungskoeffizienten der Feldproben zu bestimmen. Das lokale Signal einer Probe wird mittels der inversen Matrix bestimmt. Das Verfahren wird genutzt, um Karten von dynamischen Magnetfeldern in diffusionsgewichteter Magnetresonanzabbildung zu bestimmen. Die mittels entkoppelter Proben abgeschätzten Felder führen zu Magnetresonanzabbildungen, die robuster gegenüber Wirbelströmen sind, die durch Diffusions-Empfindlichkeits-Gradienten in unterschiedlicher Richtung sind.

Aus dem Dokument YING-HUA CHU ET AL.: "Accurate dynamic magnetic field monitoring and diffusion-weighted image reconstruction using uncorrelated local field measurements" (PROCEEDINGS OF THE INTERNATIONAL SOCIETY FOR MAGNETIC RESONANCE IN MEDICINE, ISMRM, 25TH ANNUAL MEETING AND EXHIBITION, HONOLULU, HI, USA, 22 APRIL - 27 APRIL 2017, Nr. 3915, 7. April 2017 (2017-04-07), XP040691483) ist ein Verfahren bekannt, Feldproben zu entkoppeln und die Genauigkeit bei der dynamischen Magnetfeldabschätzung zu verbessern. Eine Empfindlichkeitsmatrix von Feldproben wurde bestimmt, um Magnetresonanzsignale zu entkoppeln.

Die bisherigen Feldkameras weisen zur Auswertung der Signale der Feldsonden einzelne Antennenspulen an den Feldsonden und separate Empfänger auf, die bei einer Vielzahl von Feldsonden zur Erhöhung der räumlichen Auflösung einen erheblichen Aufwand bedeuten.

Es stellt sich daher die Aufgabe, die Magnetfeldmessung in einem Magnetresonanztomographen einfacher und kostengünstiger zu gestalten.

Die Aufgabe wird durch das erfindungsgemäße Verfahren nach Anspruch 1 gelöst.

Die in dem erfindungsgemäßen Verfahren genutzte Feldkamera weist eine Anzahl von M Proben auf. Als Proben werden dabei Volumina bezeichnet, in denen sich ein Medium befindet, dessen Kernspins eine Magnetresonanz aufweisen. Im einfachsten Fall kann es sich beispielsweise um mit Wasser gefüllte Küvetten handeln. Vorzugsweise weist das Material der Küvetten keine oder nur geringe dia- oder paramagnetische Eigenschaften auf wie beispielsweise Styropor und ist darüber hinaus als Kugelschale oder Ellipsoid geformt, um Feldverzerrungen des Magnetfeldes zu minimieren. Die Proben weisen vorzugsweise ein gegen das auszumessende Raumvolumen kleines Volumen auf, beispielsweise um den Faktor 10, 50, 100 oder 1000 kleiner als das auszumessende Raumvolumen.

Die Proben sind über das auszumessende Raumvolumen verteilt. Darunter ist zu verstehen, dass sich beispielsweise das Raumvolumen in M gleichgroße disjunkte Teilvolumina aufgeteilt ist und in jedem der Teilvolumina jeweils nur eine Probe angeordnet ist. Es ist auch denkbar, dass der Abstand zweier benachbarter Proben nicht kleiner als ein vorbestimmter Mindestabstand ist. Der Mindestabstand ist dabei vorzugsweise um mehr als den Faktor 5, 10, 20 oder 100 größer als die größte Ausdehnung der Probe in einer Raumrichtung. Als verteilt kann auch angesehen werden, dass sich nur jeweils eine Probe in jeweils einem der nachfolgend ausgeführten Empfangsvolumen angeordnet ist. Denkbar ist es auch, dass die Proben auf einer oder mehreren konzentrischen Schalen, beispielsweise Kugelschalen, um das Raumvolumen herum bzw. darin angeordnet sind. Vorteilhafter Weise lässt sich aufgrund der Feldgleichungen für Magnetfelder aus den Messwerten der Schale auf das Magnetfeld im Inneren schließen und die Anordnung in einer Schale erleichtert das nachfolgend beschriebene Ermitteln einer inversen Matrix, um aus den Signalen von Empfangsantennen auf die Magnetresonanzsignale der einzelnen Proben zu schließen. In einer bevorzugten Ausführungsform gibt es mindestens eine ausgezeichnete Achse, für die gilt, dass in einer Ebene senkrecht zu der Achse immer nur eine Probe angeordnet ist.

Die Feldkamera weist eine Anzahl von N Empfangsantennen für ein Magnetresonanzsignal auf. Die Empfangsantennen können beispielsweise Antennenspulen sein, wie sie auch in Lokalspulen Anwendung finden. Die Empfangsantennen weisen jeweils ein Empfangsvolumen auf. Als Empfangsvolumen wird dabei ein Volumen angesehen, in dem das von einer Probe in der Empfangsantenne hervorgerufene Magnetresonanzsignal nicht um mehr als dB gegenüber einem maximalen von der Probe erzeugbaren Pegel gedämpft wird. Das maximale Magnetresonanzsignal wird bei einer kreisförmigen Antennenspule beispielsweise mit einer Probe in unmittelbarer Nähe des Spulenleiters erzielt.

Die Empfangsantennen sind derart relativ zu dem auszumessenden Raumvolumen angeordnet, dass in mindestens einem der Empfangsvolumina zwei der M Proben angeordnet sind, wobei die Empfangsvolumina zumindest teilweise disjunkt sind. In jedem der Empfangsvolumina befindet sich mindestens eine Probe. Beispielsweise können sich die Proben in einem Gitter angeordnet in einem Kubus oder Zylinder befinden, auf dessen Außenseite in allen drei Raumrichtungen die Empfangsantennen angeordnet sind. Denkbar wäre es beispielsweise, als Feldkamera ein Phantom aus einem Strukturelement mit darin verteilten Proben in einer Kopfspule anzuordnen.

Die Anzahl N der Empfangsantennen ist dabei größer oder gleich der Anzahl M der Proben.

Das erfindungsgemäße Verfahren dient zum Messen einer magnetischen Feldverteilung mit einem Magnetresonanztomographen und der Feldkamera. In einem Schritt des Verfahrens wird eine Empfindlichkeitsmatrix für die Empfangsantennen bestimmt, indem zu jeder Empfangsantenne n eine Empfindlichkeit $E_{mn}$ gemessen wird, mit der ein Signal der Probe m von dieser Antenne empfangen wird. Diese Empfindlichkeit kann relativ zu den anderen Antennen angegeben werden oder absolut, beispielsweise in Mikrovolt Amplitude des empfangenen Magnetresonanzsignals $A_n$ einer Empfangsantenne n für eine vorbestimmte Anregung der Probe m. Die Messung der Amplituden erfolgt dabei vorzugsweise mit den Empfängern des Magnetresonanztomographen, die auch zur Bildrekonstruktion genutzt werden. Es wäre aber auch denkbar, dafür separate Empfänger zu verwenden.

Dazu ist es erforderlich, dass die Signale der einzelnen Proben beim Erfassen der Empfindlichkeitsmatrix getrennt bzw. unterschieden werden. Dies kann dadurch gelöst werden, dass durch einen Gradienten des Magnetfeldes die Frequenzen der einzelnen Proben beim Empfang des Magnetresonanzsignal getrennt und die Signale damit unterscheidbar werden. Es wäre aber auch denkbar, durch ein einziges Gradientenfeld bei der Anregung der Kernspins nur einzelne Proben selektiv anzuregen, wenn diese geeignet zur Richtung des Gradienten angeordnet sind.

Schließlich wäre es in einer Ausführungsform welche nicht in den Schutzumfang der Erfindung fällt auch möglich, gezielt die Selektivität für einzelne Proben zu erzielen, indem geeignete Aktivierungseinrichtungen an den Proben angeordnet sind. Zur Selektion könnten beispielsweise Spulen an den Proben dienen, mit denen ein zusätzliches lokales statisches Magnetfeld erzeugt wird oder durch ein magnetisches Wechselfeld die kohärente Anregung zerstört wird. Auch wäre es denkbar, durch eine schaltbare Abschirmung an den einzelnen Proben selektiv die Anregung zu verhindern oder die Abstrahlung des MRT-Signals. Es ist auch denkbar, die Empfindlichkeit der einzelnen Empfangsantennen durch eine Bilderfassung der Proben jeweils mit einer Empfangsantenne und der Körperspule zu machen und aus dem Verhältnis der Intensitätswerte für die einzelnen Proben die relative Empfindlichkeit der Empfangsantennen für die einzelnen Proben zu bestimmen.

Eine Beschleunigung kann dabei erzielt werden, wenn keine vollständige 3-dimensionale Erfassung erfolgt, sondern lediglich eine oder mehrere Projektionen auf zwei oder sogar nur eine Dimension aus einer oder mehreren verschiedenen Richtungen erfasst werden und deren Intensitätswerte ausgewertet werden. Die Projektionen lassen sich dadurch erzielen, dass kein Magnetfeldgradient oder nur ein Magnetfeldgradient (z.B. Gx oder Gy) bei der Erfassung der MR-Signale angelegt wird. Es entfällt also die vollständige Abtastung des k-Raums. Dadurch kann die Phasencodierung zur Abtastung des gesamten Raums entfallen.

Sind die Magnetresonanzsignale der einzelnen Proben unterscheidbar oder nur jeweils eine Probe angeregt, kann jeweils für jede Probe m die absolute bzw. relative Empfindlichkeit bestimmt werden, mit der die N Empfangsantennen jeweils die Magnetresonanzsignale der Probe m erfassen. Auf diese Weise lassen sich die Koeffizienten der Empfindlichkeitsmatrix $E_{mn}$ parallel oder auch sequentiell erfassen.

In einem weiteren Schritt des erfindungsgemäßen Verfahrens werden N Antennensignalen $A_n$ der M Proben in einem zu messenden Magnetfeld mittels der N Empfangsantennen erfasst. Im Gegensatz zu der Messung der Signale zum Bestimmen der Empfindlichkeitsmatrix $E_{mn}$ ist es dabei nicht mehr erforderlich, dass die Magnetresonanzsignale sich in der Frequenz unterscheiden oder sequentiell erfasst werden. Die Erfassung der Antennensignale erfolgt wieder vorzugsweise mit den Empfängern des Magnetresonanztomographen.

In einem anderen Schritt des erfindungsgemäßen Verfahrens werden M Magnetresonanzsignale $S_m$ der einzelnen Proben aus den N Antennensignalen $A_n$ in Abhängigkeit von der Empfindlichkeitsmatrix $E_m$ ermittelt. Es handelt sich dabei um das Auflösen des Gleichungssystems $A_n = E_{mn} \times S_m$ nach den Magnetresonanzsignalen $S_m$ der Proben. Verschiedene vorteilhafte Methoden zur Lösung werden in den nachfolgenden Unteransprüchen und in der Figurenbeschreibung aufgeführt.

Die Frequenz der separierten Magnetresonanzsignale der Proben gibt dann ein Maß für das lokale statische Magnetfeld am Ort der Proben wieder. Das Ergebnis kann dann dargestellt werden oder zur Kalibrierung von nachfolgenden Messungen genutzt werden.

Der Magnetresonanztomograph weist ein Gradientensystem auf und die Feldkamera ist in dem Magnetresonanztomographen angeordnet. Dabei weist der Schritt des Erfassens einer Empfindlichkeitsmatrix weiterhin den Schritt auf, einen Feldgradienten zu ermitteln, der jede Probe einem unterschiedlichen Magnetfeld aussetzt. Diese Bedingung ist erfüllt, wenn auf keiner Ebene senkrecht zu dem Gradientenvektor des Feldgradienten mehr als eine Probe zu liegen kommt. Das Ermitteln kann beispielsweise schon bei der Konstruktion der Feldkamera durch geeignete Anordnung der Proben im Raum zu einem vorbestimmten Gradientenvektor erfolgen. Es ist aber auch denkbar, den Gradientenvektor für eine gegebene Verteilung der Proben zu bestimmen. Denkbar ist es dabei auch, dass unterschiedliche Gradientenvektoren bestimmt werden.

In einem weiteren Schritt des erfindungsgemäßen Verfahrens wird der ermittelte Feldgradienten mittels des Gradientensystems während des Erfassens der Empfindlichkeitsmatrix $E_{mn}$ ausgegeben, insbesondere während des Kernspins.

Auf vorteilhafte Weise erlaubt die Feldkamera, durch die N Empfangsantennen, die um die M Proben angeordnet sind, aus den N Empfangssignalen die Magnetresonanzsignale der M Proben durch die Bedingung N >= M zu rekonstruieren und so die Magnetfelder an M Positionen in dem auszumessenden Raumvolumen zu bestimmen, wie im nachfolgenden Verfahren näher erläutert wird. Auch ermöglicht es die Feldkamera, dazu auch bereits vorhandene Lokalspulen als Teil der Feldkamera zu nutzen und so den Aufwand zu reduzieren.

Auf vorteilhafte Weise erlaubt es das erfindungsgemäße Verfahren mit der Feldkamera, mit einer relativ einfachen Anordnung aus Proben in einem Strukturkörper und einer Lokalspulenmatrix, beispielsweise einer Headcoil, parallel und damit schnell und ohne zusätzliche Vorrichtungen erfolgen. Als Strukturköper kommt dabei vorzugsweise ein Material ohne besondere eigene elektrische oder magnetische Eigenschaften, also ein Nichtleiter mit relativer Dielektrizitätskonstante und Suszeptibilitätskonstante nahe 1 und einer Larmorfrequenz ungleich der der Proben zur Verwendung, beispielsweis Styropor.

Weitere vorteilhafte Ausführungsformen sind in den Unteransprüchen angegeben.

In einer nicht beanspruchten Ausführungsform der Feldkamera umgeben die N Empfangsantennen das auszumessende Raumvolumen zumindest teilweise außenumfänglich. Das auszumessende Raumvolumen weist dabei zumindest das Volumen auf, das die Proben umgibt, mit anderen Worten den zusammenhängenden Raum, in dem die Proben angeordnet sind. Als zumindest teilweise außenumfänglich umgeben wird dabei im Sinne der Erfindung angesehen, dass die Empfangsantennen in zumindest drei der sechs kartesischen Raumkoordinaten um die Proben herum angeordnet sind. Denkbar ist beispielsweise, dass das Raumvolumen einen Quader oder eine Kugel beschreibt, der entlang der z-Achse bzw. der Richtung des B0-Feldes eines Magnetresonanztomographen angeordnet ist und Empfangsantennen an den Außenwänden in +/- x-Richtung und +/- y-Richtung angeordnet sind. Die Proben sind darin beispielsweise in einem Gitter oder vorzugsweise auf einer oder zwei konzentrischen Kugelschalen angeordnet. Denkbar sind auch zwei konzentrische Kugelschalen. Möglich wäre auch ein Zylinder, dessen Mantel von einem aufgerollten Antennen-Array gebildet wird. Auch können zum Beispiel Empfangsantennen in allen 6 Richtungen des Raumes an Flächen eines umgebenden Prismas oder Würfels angeordnet sein.

Durch die außenumfängliche Anordnung der Empfangsantennen wird auf vorteilhafte Weise sichergestellt, dass alle Proben von den Empfangsantennen erfasst und auch unterschiedlich gewichtet werden, sodass die Empfindlichkeitsmatrix nicht unterbestimmt ist.

In einer nicht beanspruchten Ausführungsform der Feldkamera weist mindestens eine Probe einen induktiv gekoppelten ersten Resonanzkreis bei der Larmorfrequenz auf. Darunter, dass die Probe einen ersten Resonanzkreis aufweist, ist zu verstehen, dass der erste Resonanzkreis vornehmlich mit dieser einen Probe wechselwirkt, an der er angeordnet ist. Das Signal der zugeordneten Probe erzeugt beispielsweise ein Resonanzsignal in dem Resonanzkreis, das mehr als 6 dB, 12 dB oder 18 dB über einem von einer benachbarten Probe induzierten Signal bei gleicher Anregung liegt. Wesentlich ist dabei, dass die Wechselwirkung des Resonanzkreises mit unterschiedlichen Proben unterschiedlich ist, damit eine Unterscheidung anhand der Empfindlichkeitsmatrix möglich ist. Die ist beispielsweise zu erreichen, indem der erste Resonanzkreis eine Induktivität in Form einer Spule aufweist, die die Probe in einem Abstand umgibt, der kleiner ist als eine Abmessung der Probe in einer Ebene, in der die Spule liegt. Als Larmorfrequenz wird dabei die Frequenz angesehen, bei der die Kernspins der Probe ein Magnetresonanzsignal in einem statischen B0-Feldes eines zu vermessenden Magnetresonanztomographen aufweisen, beispielsweise bei 1.5 T, 3T, 7T. Um eine Resonanz zu erzielen, kann der Resonanzkreis neben der Spule mit ihrer Eigenkapazität auch eine Kapazität aufweisen.

Auf vorteilhafte Weise verstärkt ein erster Resonanzkreis ein Signal der Probe durch eine lokale Erhöhung der Feldstärke des Anregungspulses als auch eine resonante Verstärkung des Magnetresonanzsignales beim Empfang, sodass die Magnetfeldmessung schneller und zuverlässiger erfolgen kann.

In einer nicht beanspruchten Ausführungsform weist die Feldkamera einen zweiten Resonanzkreis mit der gleichen Resonanzfrequenz wie die des ersten Resonanzkreises auf. Der erste Resonanzkreis steht mit dem zweiten Resonanzkreis in induktiver Kopplung und der zweite Resonanzkreis weist eine größere Induktionsfläche als der erste Resonanzkreis auf. Als induktive Kopplung wird dabei insbesondere angesehen, wenn bei einem beide Resonanzkreise homogen durchdringenden magnetischen Wechselfeld auf der Resonanzfrequenz der beiden Resonanzkreise die Amplitude der Ströme in dem ersten Resonanzkreis um 3 dB, 6 dB, 12 dB oder mehr über der Amplitude in dem ersten Resonanzkreis ohne den zweiten Resonanzkreis ist. Als gleiche Resonanzfrequenz wird dabei eine Frequenz angesehen, die im gekoppelten System eine Amplitude im jeweiligen Resonanzkreis erzeugt, die um weniger als 12 dB, 6 dB oder 3 dB gegenüber einer Amplitude bei gleichem Wechselfeld auf der freien Eigenresonanzfrequenz des Resonanzkreises erzeugt. Es ist dabei auch denkbar, dass der erste Resonanzkreis gegenüber dem zweiten Resonanzkreis eine andere räumliche Orientierung aufweist, beispielsweise ein Winkel zwischen einem Normalenvektor einer Antennenspule des ersten Resonanzkreises und einem Normalenvektor einer Antennenspule des zweiten Resonanzkreises größer ist als 10 Grad, 20 Grad oder 30 Grad. Denkbar ist auch, dass mehrere erste Resonanzkreise mehrere Proben mit einem gemeinsamen zweiten Resonanzkreis induktiv koppeln.

Auf vorteilhafte Weise kann der zweite Resonanzkreis aufgrund seiner größeren Fläche die Kopplung zwischen einer Sendeantenne für Anregungspulse auf der einen Seite und/oder den Empfangsantennen auf der anderen Seite mit den Proben verbessern, sodass durch kürzere Messzeiten die zeitliche Auflösung oder durch kleinere Proben die räumliche Auflösung verbessert werden kann. Bei unterschiedlichen Ausrichtungen kann darüber hinaus eine Ankopplung an die Anregungspulse verbessert werden, die im schlechtesten Fall gegen Null gehen könnte, wenn die Feldvektoren des Anregungsfeldes parallel zur Fläche der Antennenspule des ersten Resonanzkreises sind.

In einer nicht beanspruchten Ausführungsform der Lokalspule weist der Resonanzkreis eine Spule und eine Kapazität auf, wobei die Kapazität aus verdrillten, isolierten Leiterenden der Spule gebildet ist.

Die durch Lack isolierten, verdrillten Leiterenden bilden durch die gegenüberliegenden, voneinander im Bereich der Kapazität isolierten Leiter eine kleine Kapazität mit hoher Güte für den Resonanzkreis aus, die ohne zusätzliche mechanisch anfällige Lötstellen und möglicherweise die Magnetresonanzmessung verfälschende Materialien auskommt.

Es ist dabei auch denkbar, dass der Resonanzkreis zwei Resonanzfrequenzen aufweist, beispielsweise indem er zwei Schwingkreise für unterschiedliche Resonanzfrequenzen aufweist, die miteinander gekoppelt sind.

Auf vorteilhafte Weise erlaubt es der doppelt resonante Resonanzkreis, eine Feldkamera für zwei unterschiedliche B0-Magnetfeldstärken wie 1,5 T und 3 T bereitzustellen.

In einer möglichen Ausführungsform weist das erfindungsgemäße Verfahrens den Schritt auf, eine inversen Matrix $I_{nm}$ zu der Empfindlichkeitsmatrix $E_{mn}$ zu bestimmen;

Der Begriff inverse Matrix ist hier nicht auf den engeren mathematischen Begriff für quadratische Matrizen mit M = N beschränkt, sondern umfasst beispielsweise auch die sogenannten pseudoinversen Matrizen mit N > M, beispielsweise Moore-Penrose-Inverse.

Dazu ist es erforderlich, dass das Gleichungssystem der Empfindlichkeitsmatrix $E_{mn}$ nicht unterbestimmt ist. Bei einer quadratischen Matrix ist dies gegeben, wenn die Determinante ungleich Null ist. Dies kann durch geeignete Verteilung von Proben und Empfangsantennen erzielt werden, sodass nicht identische Signale bzw. Signalkombinationen gleicher Proben in zwei unterschiedlichen Empfangsantennen erfasst werden. Dafür ist es notwendig, dass die Anzahl N der Empfangsantennen mindestens so groß ist wie Anzahl M der Proben.

Ist das Gleichungssystem überbestimmt, also die Anzahl der Empfangsantennen N größer als die Anzahl der Proben M und die Anordnung der Proben zu den Empfangsspulen derart, dass die gleichen Signalkombinationen von Proben in unterschiedlichen Empfangsantennen erfasst werden, kann mittels Selbstwertzerlegung oder Ränderung eine pseudoinverse Matrix $I_{nm}$ aus der Empfindlichkeitsmatrix $E_{mn}$ ermittelt werden. Dabei lässt sich mit der Methode der kleinsten Quadrate eine Lösung mit minimalem Abstand und verbessertem Rauschabstand bestimmen.

Das Invertieren der Matrix kann beispielsweise in einer Steuereinheit des Magnetresonanztomographen erfolgen, es wäre aber auch eine separate Recheneinheit denkbar.

In einem weiteren möglichen Schritt des erfindungsgemäßen Verfahrens werden die erfassten Magnetresonanzsignale $S_m$ der einzelnen Proben mittels einer Multiplikation des Vektors $A_N$ aus den N Antennensignalen mit der inversen Matrix $I_{nm}$ zurückgewonnen. Die Berechnung kann auch wieder durch eine Steuereinheit des Magnetresonanztomographen oder eine Bildrekonstruktionseinheit erfolgen.

Es ist dabei von besonderem Vorteil, dass die inverse Matrix immer wieder auf nachfolgende Messungen der Antennensignale angewendet werden kann, sofern sich nicht die relative Anordnung der Empfangsantennen zu den Proben ändert. Auf diese Weise sind Magnetfeldmessungen und Auswertungen mit einer hohen Wiederholungsrate möglich.

Grundsätzlich wäre es aber auch denkbar, das Gleichungssystem jeweils wieder individuell neu zu lösen. Für derartige überbestimmte Gleichungssysteme mit fehlerbehafteten Koeffizienten gibt es eine Vielzahl mathematischer Lösungsverfahren. So wäre es denkbar, dass vor allem bei einem überbestimmten Gleichungssystem bei bestimmten Konstellationen mit speziellen Eingangsvektoren oder nur teilbesetzten Empfindlichkeitsmatrizen schneller und/oder genauere Lösungen gefunden werden können.

Neben der selektiven Anregung einzelner Proben ist es aber auch denkbar, über die Kombination mehrere Projektionen der Proben entlang unterschiedlicher Achsen auf eine oder zwei Dimensionen eine Empfindlichkeitsmatrix zu erhalten. Dies kann erreicht werden, indem der k-Raum nur entlang einer Achse abgetastet wird oder nur die Amplituden erfasst werden.

In einer möglichen Ausführungsform des erfindungsgemäßen Verfahrens weist der Schritt des Erfassens einer Empfindlichkeitsmatrix weiterhin den Unterschritte auf die Antennensignale mit einer zeitabhängigen Fensterfunktion zum Schärfen einer spektralen Verteilung während des Erfassens der Empfindlichkeitsmatrix im Zeitbereich zu gewichten. Denkbar sind beispielsweise eine abfallende Exponentialfunktion oder eine Hann-Funktion.

Durch den Feldgradienten werden die Magnetresonanzsignale der einzelnen Proben auf unterschiedliche Larmorfrequenzen verschoben, sodass die Signale unterscheidbar werden. Dennoch kann wegen der endlichen Länge der Abtastfenster und der Dauer des erfassbaren Magnetresonanzsignals die Auflösung im Fourier-Raum zur Trennung nicht ausreichen. Auf vorteilhafte Weise erzielt eine geeignete Gewichtung mit einer Fensterfunktion, die auch die exponentiell abfallende Signalstärke berücksichtigt, eine bessere Auflösung im Frequenzraum.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden.

Es zeigen:

Fig. 1    eine schematische Übersichtsdarstellung eines Magnetresonanztomographen mit einer Feldkamera für das erfindungsgemäße Verfahren;

Fig. 2    eine schematische Darstellung einer Anordnung von Proben einer Feldkamera für das erfindungsgemäße Verfahren;

Fig. 3    eine schematische Darstellung von Empfangsantennen einer Feldkamera für das erfindungsgemäße Verfahren;

Fig. 4    einen schematischer Ablaufplan eines erfindungsgemäßen Verfahrens.

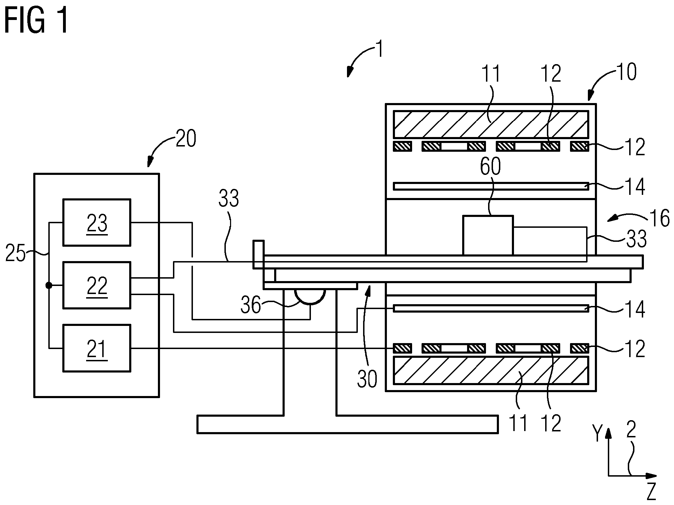

Fig. 1 zeigt eine schematische Darstellung einer Ausführungsform eines Magnetresonanztomographen 1 mit einer Feldkamera 60 für das erfindungsgemäße Verfahren.

Die Magneteinheit 10 weist einen Feldmagneten 11 auf, der ein statisches Magnetfeld B0 zur Ausrichtung von Kernspins von Proben bzw. des Patienten in einem Aufnahmebereich erzeugt. Der Aufnahmebereich zeichnet sich durch ein äußerst homogenes statisches Magnetfeld B0 aus, wobei die Homogenität insbesondere die Magnetfeldstärke bzw. den Betrag betrifft. Der Aufnahmebereich ist nahezu kugelförmig und in einem Patiententunnel 16 angeordnet, der sich in einer Längsrichtung 2 durch die Magneteinheit 10 erstreckt. Eine Patientenliege 30 ist in dem Patiententunnel 16 von der Verfahreinheit 36 bewegbar. Üblicherweise handelt es sich bei dem Feldmagneten 11 um einen supraleitenden Magneten, der magnetische Felder mit einer magnetischen Flussdichte von bis zu 3T, bei neuesten Geräten sogar darüber, bereitstellen kann. Für geringere Feldstärken können jedoch auch Permanentmagnete oder Elektromagnete mit normalleitenden Spulen Verwendung finden.

Weiterhin weist die Magneteinheit 10 Gradientenspulen 12 auf, die dazu ausgelegt sind, zur räumlichen Differenzierung der erfassten Abbildungsbereiche in dem Untersuchungsvolumen dem Magnetfeld B0 variable Magnetfelder in drei Raumrichtungen zu überlagern. Die Gradientenspulen 12 sind üblicherweise Spulen aus normalleitenden Drähten, die zueinander orthogonale Felder in dem Untersuchungsvolumen erzeugen können.

Die Magneteinheit 10 weist ebenfalls eine Körperspule 14 auf, die dazu ausgelegt ist, ein über eine Signalleitung zugeführtes Hochfrequenzsignal in das Untersuchungsvolumen abzustrahlen und von dem Patient 100 emittierte Resonanzsignale zu empfangen und über eine Signalleitung abzugeben.

Eine Steuereinheit 20 versorgt die Magneteinheit 10 mit den verschiedenen Signalen für die Gradientenspulen 12 und die Körperspule 14 und wertet die empfangenen Signale aus.

So weist die Steuereinheit 20 eine Gradientenansteuerung 21 auf, die dazu ausgelegt ist, die Gradientenspulen 12 über Zuleitungen mit variablen Strömen zu versorgen, welche zeitlich koordiniert die erwünschten Gradientenfelder in dem Untersuchungsvolumen bereitstellen.

Weiterhin weist die Steuereinheit 20 eine Hochfrequenzeinheit 22 auf, die ausgelegt ist, einen Hochfrequenz-Puls mit einem vorgegebenen zeitlichen Verlauf, Amplitude und spektraler Leistungsverteilung zur Anregung einer Magnetresonanz der Kernspins in dem Patienten 100 zu erzeugen. Dabei können Pulsleistungen im Bereich von Kilowatt erreicht werden. Die Anregungspulse können über die Körperspule 14 oder auch über eine lokale Sendeantenne in den Patienten 100 abgestrahlt werden.

Eine Steuerung 23 kommuniziert über einen Signalbus 25 mit der Gradientensteuerung 21 und der Hochfrequenzeinheit 22.

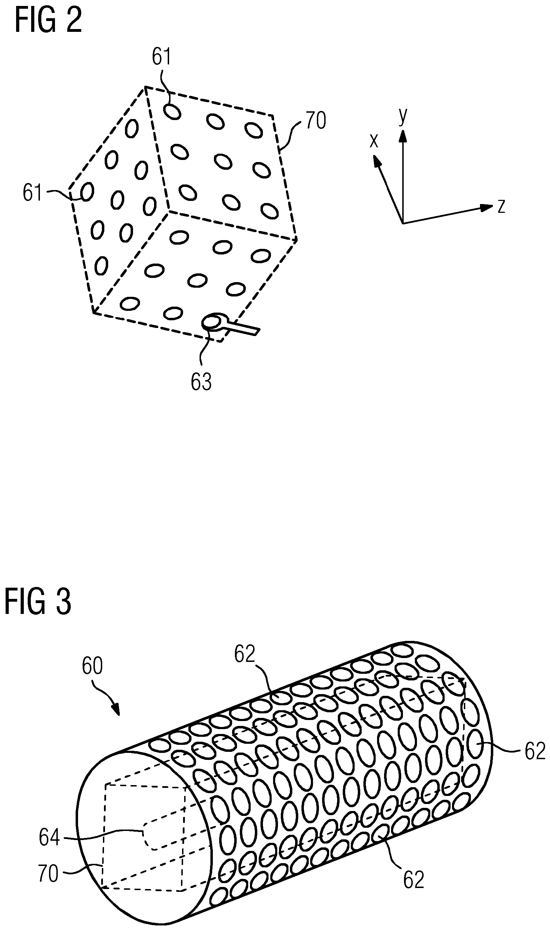

Auf der Patientenliege 30 ist anstelle des Patienten eine Feldkamera 60 angeordnet, um das Magnetfeld im Patiententunnel 16 zu vermessen. Die Feldkamera 60 weist wie in Fig. 2 und Fig. 3 dargestellt Proben 61 und Empfangsantennen 62 auf, wobei die Empfangsantennen 62 über eine Anschlussleitung 33 in Signalverbindung mit Empfängern der Hochfrequenzeinheit 22 stehen. Die Signalverbindung kann auch drahtlos ausgeführt sein.

In Fig. 2 sind die Proben 61 einer Feldkamera 60 schematisch dargestellt.

Die Feldkamera 60 weist eine Anzahl von M Proben 61 auf, die vorzugsweise an der Oberfläche eines auszumessenden Raumvolumens 70 verteilt sind. Die Proben 61 weisen ein bezüglich Kernspinresonanz aktives Material auf. Es kann sich dabei um wasserstoffhaltige Proben 61 handeln wie Wasser oder Kohlenwasserstoffverbindungen. Flüssige Proben 61 können in Küvetten bzw. Phiolen enthalten sein. Die Proben 61 können in eine Matrix bzw. einen Strukturkörper eingebettet sein, die selbst keine Kernspinresonanz aufweist oder auf einer anderen Frequenz aktiv ist. Die Größe der Proben 61 ist dabei ein Kompromiss aus räumlicher Auflösung und Empfindlichkeit. Je größer die Proben 61 sind, desto geringer ist die räumliche Auflösung.

Das Raumvolumen 70 ist hier als Kubus dargestellt, um die Orientierung der Raumachsen einfacher darstellen zu können. Das Raumvolumen 70 kann aber auch beliebige andere Formen annehmen, denkbar sind beispielsweise auch Kugel, Ellipsoid, Zylinder, Prisma oder ähnliche Anordnungen, die den Aufnahmebereich zumindest teilweise ausfüllen. Vorteilhaft sind auch eine oder mehrere konzentrische Kugelschalen, auf denen die Proben 61 angeordnet sind, da aufgrund der magnetischen Feldgesetze sich aus den Feldern an der Oberfläche eines quellenfreien Volumens die Felder im Inneren bestimmen lassen.

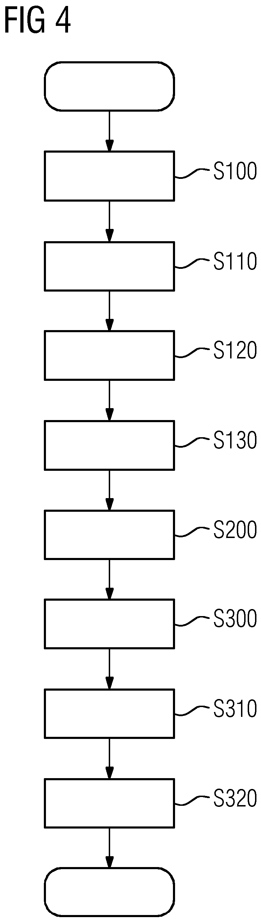

Für das erfindungsgemäße Verfahren ist es dabei notwendig, wenn die Proben 61 so angeordnet sind, dass immer nur eine auf einer Ebene senkrecht zu einem Gradientenvektor zu liegen kommt. Dies ermöglicht es, in dem zu Fig. 4 erläuterten Verfahren die Proben 61 anhand der Larmorfrequenz unter der Einwirkung des magnetischen Gradienten zu unterscheiden.

Die kann erreicht werden, indem die Proben 61 in einem regelmäßigen Gitter angeordnet ist, dessen Symmetrieachsen gegenüber Grundachsen x, y und z der Gradientenspulen 12 geeignet verkippt sind. Denkbar ist aber auch eine geeignete willkürliche oder regelmäßige Verteilung. Schließlich ist es auch denkbar, dass zwar die Achsen der Anordnung der Proben 61 parallel zu den Achsen der Gradientenspulen 12 sind, aber durch geeignete Überlagerung der Magnetfelder der Gradientenspulen 12 einen Magnetfeldgradienten gerade so erzeugt, dass die Bedingung erfüllt ist.

Zur Beschleunigung der Messung ist es auch denkbar, dass um die einzelnen Proben 61 Störspulen 63 vorgesehen sind, die mit einem Gleich- oder Hochfrequenzstrom beaufschlagt werden können, um eine noch bestehende Anregung schneller abklingen zu lassen, damit die nächste Messung schneller folgen kann.

Schließlich kann, wie noch zum Verfahren erläutert, auch durch mehrere Magnetresonanzabbildungen der Proben 61 mit Projektion auf eine zweidimensionale Fläche oder eine eindimensionale Linie die relative Empfindlichkeit der einzelnen Empfangsantennen 62 für die einzelnen Proben 61 ermittelt werden.

Der Übersicht halber sind die Empfangsantennen 62 der Feldkamera 61 beispielhaft in einer eigenen Fig. 3 dargestellt. Die Empfangsantennen 62 weisen jeweils ein Empfangsvolumen 64 auf und sind derart relativ zu dem auszumessenden Raumvolumen angeordnet, dass in mindestens einem der Empfangsvolumina 64 zwei der M Proben angeordnet sind und die Empfangsvolumina 64 zumindest teilweise disjunkt sind und in jedem Empfangsvolumen mindestens eine Probe angeordnet ist. Die Anzahl N der Empfangsantennen ist dabei größer oder gleich der Anzahl M der Proben.

In Fig. 3 ist eine mögliche Konfiguration an Empfangsantennen 62 der Feldkamera 60 dargestellt. Die Empfangsantennen 62 sind hier beispielhaft als Antennenspulen dargestellt. Das Raumvolumen 70 ist dabei zumindest teilweise von den Empfangsantennen 62 außenumfänglich umgeben. Die Proben 61 innerhalb des Raumvolumens 70 sind in Fig. 3 der Übersichtlichkeit halber nicht dargestellt, sondern sind wie in Fig. 2 dargestellt innerhalb des Raumvolumens 70 angeordnet.

In Fig. 3 sind die Empfangsantennen 61 außenumfänglich an einem Hohlkörper angeordnet. Es kann sich dabei wie dargestellt beispielsweise auch um eine Kopfspule handeln, die wie bei einem bekannten Modell mit 64 einzelnen Empfangsspulen als Empfangsantennen 62 Magnetresonanzsignale aus dem Innenraum empfängt, indem das Raumvolumen 70 mit den Proben 61 angeordnet ist. So lässt sich mit geringem Aufwand bei einer vorhandenen Kopfspule durch einen Einsatz einer kostengünstigen passiven Matrix mit den Proben 61 eine Feldkamera bereitstellen.

Die Idee der vorliegenden Erfindung ist es dabei, dass die Signale der einzelnen Proben 61 aus den Empfangssignalen der Empfangsantennen 62 zurückgewonnen werden können, wenn die Signale der M Proben 61 mit den N Antennenempfangssignalen ein lösbares lineares Gleichungssystem bilden.

Dazu ist es erforderlich, dass die Anzahl N der Empfangsantennen 62 größer oder zumindest gleich der Anzahl M der Proben ist. Weiterhin müssen die Signale von allen Proben 61 von mindestens jeweils einer Empfangsantenne 62 empfangen werden. Beispielhaft ist in Fig. 3 ein Empfangsvolumen 64 für eine Empfangsantenne 62 angedeutet. Die Kontur gibt dabei die Fläche an, auf der Signale von Proben 61 um einen vorbestimmten Wert gegenüber einer Probe in der Mitte der Antennenspule gedämpft werden, im Rahmen der beanspruchten Erfindung liegt dieser Wert bei 40 dB.

Das Empfangsvolumen 64 ist maximal begrenzt durch den Abstand, bei dem das Empfangssignal unter den Rauschpegel sinkt. Das Empfangsvolumen 64 der Empfangsantenne 62 ist in Fig. 3 ein keulenförmiges Gebilde, dass sich radial nach innen erstreckt. Die Keule radial nach Außen ist der Übersichtlichkeit halber nicht dargestellt.

Bei N=M ist es für die Lösbarkeit des Gleichungssystems erforderlich, dass die Empfangsvolumina 64 zweier Empfangsantennen 62 nicht identisch sind in dem Sinne, dass bei beiden Empfangsantennen 62 für die gleichen Proben 61 die gleichen bzw. mit dem gleichen Faktor skalierte Signalpegel liefern. Es ist aber keine 1:1 Zuordnung von Empfangsantennen 62 zu Proben 61 erforderlich, sondern es können auch einige Empfangsantennen 62 ein großes Empfangsvolumen 64 abdecken, während andere nur eine einzelne Probe 61 detektieren.

Um das lineare Gleichungssystem zwischen Proben 61 und Signalen der Empfangsantennen 62 zu bestimmen, ist ein Weg, das Empfangssignal aller N Empfangsantennen 62 jeweils für eine einzelne Probe 61 nacheinander für alle M Proben 61 zu bestimmen. Dies ist beispielsweise möglich, wenn nur eine Probe 61 angeregt wird oder die Signale unterscheidbar sind.

Erfindungsgemäß wird ein Magnetfeldgradient angelegt, bei dem jede Probe 61 einem anderen statischen Magnetfeld aus Magnetfeld B0 und Gradientenfeld ausgesetzt ist. Dann kann entweder mit einem schmalbandigen Anregungspuls nur eine einzelne Probe 61 angeregt werden und von den Empfangsantennen 62 das einzelne Signal dieser Probe 61 ausgewertet wird.

Oder man könnte bei einer breitbandigen Anregung mit allen Empfangsantennen 62 die Signale aller Proben 61 empfangen und im Frequenzraum anhand der unterschiedlichen Frequenzen trennen. Maßnahmen zu einer verbesserten Frequenztrennung sind nachfolgen zu dem erfindungsgemäßen Verfahren beschrieben.

In einer nicht beanspruchten Ausführungsform wäre es aber auch denkbar, in einer Ausführungsform mit Störspulen 63 um die einzelnen Proben jeweils eine Probe selektiv mit einem Anregungspuls über diese Störspule 63 anzuregen.

Eine beispielhafte Kopfspule mit einer Anzahl von 64 Empfangsantennen 62 könnte also in Verbindung mit bis zu 64 Proben 61 ein Magnetfeld im Inneren der Kopfspule messen. Dazu ist es lediglich erforderlich, die Proben 61 wie bereits beschrieben in einer Matrix bzw. einem Formkörper anzuordnen und diesen dann in einer vorbestimmten Lage in der Kopfspule anzuordnen, sodass wie bereits beschrieben die einzelne Anregung und unterschiedliche Empfangssignale möglich sind. Denkbar ist es auch, durch resonante Spulen an den Proben als ersten Resonanzkreis eine Kopplung der Proben 61 mit dem Anregungspuls und/oder den Empfangsantennen 62 zu verbessern und so die Signalstärke und das SNR zu verbessern. Der erste Resonanzkreis kann dabei auch zwei unterschiedliche Resonanzfrequenzen z.B. durch Verkopplung von zwei Schwingkreisen aufweisen, sodass die Signalverstärkung auch bei unterschiedlichen statischen B0-Feldern möglich ist.

Auch könnte ein zweistufiges Konzept mit einem ersten Resonanzkreis unmittelbar an der Probe und einem zweiten Resonanzkreis mit größerem Abstand, dafür aber auch größerer Induktionsfläche der Antennenspule, die Kopplung weiter verbessern.

In Fig. 4 ist ein schematischer Ablaufplan eines erfindungsgemäßen Verfahrens zum Messen einer magnetischen Feldverteilung mit einem Magnetresonanztomographen 1 und einer Feldkamera 60 angegeben.

In einem Schritt S100 wird eine Empfindlichkeitsmatrix für die Empfangsantennen mit einer Empfindlichkeit $E_{mn}$ für jede Probe m an jeder Empfangsantenne n erfasst. Dazu ist es erforderlich, für eine vorbestimmte Anregung einer jeden Probe m die Signalantwort für mindestens M, besser noch N mit N > M Empfangsantennen 62 zu erfassen. Für einen Signalvektor mit den Magnetresonanzsignalen $S_m$ der M Proben 61 und einem Antennensignalvektor mit den Empfangssignalen $A_n$ der N Empfangsantennen 62 ergibt sich das Gleichungssystem:

$$A_n = E_{mn} \ x \ S_m$$

Eine mögliche Ausführungsform zur Bestimmung der Matrixelemente der Empfindlichkeitsmatrix ist es, jede der M Proben 61 nacheinander einzeln anzuregen. Dies kann beispielsweise erreicht werden, indem in einem Schritt S120 ein magnetischer Feldgradient erzeugt wird, bei dem jeweils jede der M Proben 61 einem im Betrag unterschiedlichen Magnetfeld ausgesetzt ist. Dies kann erreicht werden, indem wie schon beschrieben die Proben relativ zu dem Magnetfeldgradienten so angeordnet sind, dass nur jeweils eine Probe 61 in einer Ebene senkrecht zu dem Gradientenvektor angeordnet ist. Entweder sind dabei die Proben 61 entsprechend zu einem Gradientenvektor der einzelnen Gradientenspulen 12 in X-, Y- oder Z-Richtung ausgerichtet, sodass es reicht, die jeweilige Gradientenspule 12 mit Strom zu beaufschlagen. Oder es wird in einem Schritt S110 ein geeigneter Gradientenvektor ermittelt und in einem Schritt S120 durch Überlagerung der Felder der drei Gradientenspulen 12 ein Gradientenvektor in geeigneter Richtung relativ zu den Proben 61 erzeugt.

Wenn jede der M Proben einem jeweils unterschiedlichen Magnetfeld ausgesetzt sind, das sich aus dem Gradientenmagnetfeld und dem statischen Magnetfeld B0 zusammensetzt, weisen diese auch unterschiedliche Larmorfrequenzen auf. Durch einen schmalbandigen Anregungspuls mit der jeweiligen Larmorfrequenz kann dann jeweils eine einzelne Probe individuell angeregt werden und anschließend das Magnetresonanzsignal dieser einen Probe 61 von allen N Empfangsantennen 62 empfangen werden, um die jeweiligen Matrixelemente der Empfindlichkeitsmatrix $E_{mn}$ zu erfassen.

Es wäre auch denkbar, unter Einwirkung des gleichen Magnetfeldgradienten einen breitbandigen Anregungspuls auszusenden, der Signalanteile mit der Larmorfrequenz aller Proben unter Einwirkung dieses Magnetfeldgradienten und des statischen Magnetfeldes B0 aufweist. Die M Proben werden dann alle gleichzeitig angeregt. Werden anschließend die Magnetresonanzsignale bei unveränderten Magnetfeldern mit den Empfangsantennen 62 aufgenommen, so sind diese eine Überlagerung mehrerer Magnetresonanzsignale unterschiedlicher Proben 61. Da sich jedoch die Larmorfrequenzen unterscheiden, kann beispielsweise nach einer Fouriertransformation eine Trennung im Frequenzraum erfolgen und so die einzelnen Elemente der Empfindlichkeitsmatrix $E_{mn}$ bestimmt werden.

Reicht der Frequenzabstand nicht zu einer sauberen Trennung aus, ist es auch denkbar, die Trennschärfe durch eine Gewichtung der Empfangssignale der Empfangsantennen 62 mit einer Fensterfunktion wie der Hann- oder Gauß-Funktion zu erhöhen. Darüber hinaus kann durch eine exponentiell ansteigende Gewichtung der natürliche Abfall des Magnetresonanzsignals ausgeglichen und die Linienbreite reduziert werden.

Denkbar wäre es auch, die Trennschärfe durch eine Kombination einer selektiven Anregung und eine Auswertung im Frequenzraum zu erhöhen. Entweder könnten einzelne Proben selektiv angeregt werden oder auch in mehreren voneinander beabstandeten Schichten.

Schließlich wäre es in einer nicht beanspruchten Ausführungsform auch denkbar, bei einer Ausführungsform mit Störspule 63 um die einzelnen Proben 61, die Störspulen 63 für eine selektive lokale Anregung einer einzelnen Probe 61 mittels eines an die jeweilige Störspule 63 angelegten Anregungspulses anzuregen.

In einem Schritt S310 wird eine inverse Matrix $I_{nm}$ zu der Empfindlichkeitsmatrix $E_{mn}$ bestimmt. Dafür ist es notwendig, dass die Anzahl N der Empfangsantennen mindestens so groß ist wie Anzahl M der Proben. Die Empfindlichkeitsmatrix $E_{mn}$ gibt dabei ein Gleichungssystem an, dass unter bestimmten Bedingungen umkehrbar ist, sodass aus den Empfangssignalen bzw. der Amplitude $A_n$ der Empfangsantennen 62 auf die Magnetresonanzsignale der einzelnen Proben 61 geschlossen werden kann.

Rechnerisch erfolgt dies mit einer zu $E_{mn}$ inversen Matrix $I_{nm}$ Eine quadratische Matrix $E_{nm}$ ist dabei umkehrbar, wenn die Determinate ungleich 0 ist. Dann ergibt sich der Vektor Magnetresonanzsignale gemäß $S_m = I_{nm} \times A_n$ aus den Empfangssignalen $A_n$ der Empfangsantennen 62.

Ist die Zahl N der Empfangsantennen 62 größer als die Anzahl M der Proben 61, so ist hier der Begriff inverse Matrix nicht auf den engeren mathematischen Begriff für quadratische Matrizen mit M = N beschränkt, sondern umfasst auch die sogenannten Pseudoinversen Matrizen mit N > M, wie beispielsweise Moore-Penrose-Inverse.

Dazu ist es erforderlich, dass das Gleichungssystem der Empfindlichkeitsmatrix $E_{mn}$ nicht unterbestimmt ist. Ist das Gleichungssystem überbestimmt, also die Anzahl N der Empfangsantennen 62 größer als die Anzahl M der Proben 61 und die Anordnung der Proben 61 zu den Empfangsantennen 62 derart, dass nicht identische Linearkombinationen von Signalen von Proben 61 in unterschiedlichen Empfangsantennen 62 erfasst werden, kann mittels Selbstwertzerlegung oder Ränderung eine pseudoinverse Matrix $I_{nm}$ aus der Empfindlichkeitsmatrix ermittelt werden. Daraus wiederum lässt sich mit der Methode der kleinsten Quadrate eine Lösung mit minimalem Abstand und verbessertem Rauschabstand für die Magnetresonanzsignale $S_m$ der Proben 61 bestimmen.

Das Invertieren der Matrix kann beispielsweise in einer Steuereinheit 20 des Magnetresonanztomographen 1 erfolgen, es wäre aber auch eine separate Recheneinheit oder ein für die Bildrekonstruktion verwendete Recheneinheit denkbar.

In einem weiteren Schritt S200 werden N Antennensignale $A_n$ der M Proben 61 in einem zu messenden Magnetfeld mittels der N Empfangsantennen 62 erfasst. Dazu ist zunächst eine Anregung der Proben 61 durch einen Anregungspuls mit der Larmorfrequenz bei einem erwarteten Magnetfeld B0 erforderlich. Da die Trennung der Magnetresonanzsignale der einzelnen Proben 61 anschließend anhand der räumlichen Diversität der Empfindlichkeitsmatrix $E_{mn}$ bzw. deren Inversen $I_{nm}$ erfolgt, ist es nicht erforderlich, die einzelnen Proben 61 einem unterschiedlichen Magnetfeld durch einen Gradienten auszusetzen. Die Anregung kann daher mit einem schmalbandigen gemeinsamen Anregungspuls erfolgen, dessen Frequenz die Larmorfrequenz der Proben 61 bei dem erwarteten statischen Magnetfeld B0 ist. Die Bandbreite des Anregungspulses muss lediglich groß genug sein, um Inhomogenitäten des statischen Magnetfeldes B0 auszugleichen. Anschließend werden mit den Empfangsantennen 62 die N Amplitudenwerte erfasst bzw. der Vektor der Antennensignale $A_n$ der M Proben 61.

In einem Schritt S320 werden anschließend die Magnetresonanzsignale $S_m$ der einzelnen Proben 62 mittels einer Multiplikation des Vektors $A_N$ mit der inversen Matrix $I_{nm}$ bestimmt. Für eine überbestimmte Matrix mit N > M tritt hier anstelle der quadratischen inversen Matrix eine pseudoinverse Matrix bzw. ein Gleichungssystem, das beispielsweise nach der Methode der kleinsten Quadrate gelöst werden kann.

Auf vorteilhafte Weise bleibt dabei die inverse Matrix unverändert, solange nicht durch z.B. räumliche Veränderungen die Empfindlichkeitsmatrix verändert wird. So kann die inverse Matrix zu einer schnellen Berechnung der Magnetresonanzsignale für eine Vielzahl schnell aufeinanderfolgender Messungen genutzt werden.

Es ist aber auch denkbar, dass unter besonderen Konfigurationen von Empfangsantennen 62 und oder Proben 61 andere Lösungsverfahren des zugrunde liegenden Gleichungssystems $A_n = E_{mn} \times S_m$ ein genaueres oder schnelleres Ergebnis liefern. So ist es ebenso denkbar, dass die Lösung des Gleichungsverfahrens individuell nach jeder Messung in Abhängigkeit von den jeweiligen Antennensignalen erfolgt und daran angepasst wird.

Eine Auswertung so erhaltenen einzelnen Magnetresonanzsignale $S_m$ der einzelnen Proben 61 nach der Frequenz, beispielsweise durch eine Fouriertransformation ergibt wiederum einen Wert, der direkt proportional zu dem Magnetfeld am Ort der Probe 61 ist. Die Auswertung erfolgt vorzugsweise auf der Steuereinheit 20 des Magnetresonanztomographen 1

Der so ermittelte Magnetfeldwert kann einem Nutzer über eine Anzeige ausgegeben werden, um die Homogenität des Magnetfeldes B0 zu bewerten. Es ist aber auch denkbar, dass die Steuereinheit 20 aus den B0-Werten eine Einstellung für Shim-Ströme durch Shimming-Spulen des Magnetresonanztomographen 1 ermittelt und diese ausgibt, um die Homogenität des statischen Magnetfeldes B0 zu verbessern.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen, welcher alleinig durch die Ansprüche definiert ist.

**Patentansprüche**

1. Verfahren zum Messen einer magnetischen Feldverteilung in einem auszumessenden Raumvolumen mit einem Magnetresonanztomographen (1) und einer Feldkamera (60) zum Erfassen einer Magnetfeldverteilung mittels einer Magnetresonanzmessung, wobei die Feldkamera (60) aufweist:

   eine Anzahl von M Proben (61), die über das auszumessendes Raumvolumen (70) verteilt sind;
   eine Anzahl von N Empfangsantennen (62), wobei die Empfangsantennen (62) jeweils ein Empfangsvolumen (64) aufweisen, in dem das von einer Probe in der Empfangsantenne hervorgerufene Magnetresonanzsignal nicht um mehr als 40 dB gegenüber einem maximalen von der Probe erzeugbaren Pegel gedämpft wird, und derart relativ zu dem auszumessenden Raumvolumen (70) angeordnet sind, dass in mindestens einem der Empfangsvolumina (64) zwei der M Proben (61) angeordnet und die Empfangsvolumina (64) zumindest teilweise disjunkt sind, und in jedem Empfangsvolumen (64) mindestens eine Probe (61) angeordnet ist, wobei die Anzahl N der Empfangsantennen (62) größer oder gleich der Anzahl M der Proben (61) ist,

wobei das Verfahren die Schritte aufweist:

   (S100) Erfassen einer Empfindlichkeitsmatrix für die Empfangsantennen (62) mit einer Empfindlichkeit $E_{mn}$ für jede Probe (61) m an jeder Empfangsantenne (62) n mit dem Magnetresonanztomographen (1);
   (S200) Erfassen von N Antennensignalen $A_n$ der M Proben (61) in einem zu messenden Magnetfeld mittels der N Empfangsantennen (62) mit dem Magnetresonanztomographen (1);
   (S300) Ermitteln der M Magnetresonanzsignale $S_m$ der einzelnen Proben aus den N Antennensignalen $A_n$ in Abhängigkeit von der Empfindlichkeitsmatrix $E_{mn}$ mit einer Steuerung (23),

wobei der Magnetresonanztomograph (1) ein Gradientensystem aufweist und die Feldkamera (60) in dem Magnetresonanztomographen (1) angeordnet ist,
**dadurch gekennzeichnet, dass**
der Schritt (S100) des Erfassens einer Empfindlichkeitsmatrix weiterhin die Unterschritte aufweist:

   (S110) Ermitteln eines Magnetfeldgradienten, unter dessen Einwirkung jede Probe (61) einem unterschiedlichen Magnetfeld ausgesetzt ist;
   (S120) Erzeugen des ermittelten Feldgradienten mittels des Gradientensystems während des Erfassens der Empfindlichkeitsmatrix $E_{mn}$.

2. Verfahren nach Anspruch 1, wobei das Verfahren weiterhin die Schritte aufweist:

   (S310) Bestimmen der inversen Matrix $I_{nm}$ zu der Empfindlichkeitsmatrix $E_{mn}$;
   (S320) Bestimmen der Magnetresonanzsignale $S_m$ der einzelnen Proben durch eine Multiplikation eines Vektors $A_N$ aus den N Antennensignalen mit der inversen Matrix $I_{nm}$.

3. Verfahren nach Anspruch 1, wobei der Schritt (S100) des Erfassens einer Empfindlichkeitsmatrix weiterhin die Unterschritte aufweist:

(S130) Gewichten der Antennensignale mit einer zeitabhängigen Fensterfunktion zum Schärfen einer spektralen Verteilung während des Erfassens der Empfindlichkeitsmatrix.

4. Verfahren nach einem der vorhergehenden Ansprüche, wobei die N Empfangsantennen (62) der Feldkamera (60) das Raumvolumen (70) zumindest teilweise außenumfänglich umgeben.

5. Verfahren nach einem der vorhergehenden Ansprüche, wobei mindestens eine Probe (61) der Feldkamera (60) einen ersten Resonanzkreis mit einer Resonanz bei der Larmorfrequenz aufweist, wobei die Feldkamera einen zweiten Resonanzkreis aufweist, wobei der erste Resonanzkreis mit dem zweiten Resonanzkreis in induktiver Kopplung steht und der zweite Resonanzkreis eine größere Induktionsfläche als der erste Resonanzkreis aufweist.

6. Verfahren nach Anspruch 5, wobei der erste Resonanzkreis eine Spule aufweist und eine Kapazität, wobei die Kapazität aus verdrillten, isolierten Leiterenden der Spule gebildet ist.

7. Verfahren nach Anspruch 5 oder 6, wobei der erste Resonanzkreis zwei unterschiedliche Resonanzfrequenzen aufweist.

8. Computerprogrammprodukt, welches direkt in einen Prozessor einer programmierbaren Steuerung (23) eines Magnetresonanztomographen (1) mit einer Feldkamera (60) nach Anspruch 1 ladbar ist, mit Programmcode-Mitteln, um alle Schritte eines Verfahrens nach einem der Ansprüche 1 bis 7 auszuführen, wenn das Programmprodukt auf der Steuerung (23) ausgeführt wird.

9. Computerlesbares Speichermedium mit darauf gespeicherten elektronisch lesbaren Steuerinformationen, welche derart ausgestaltet sind, dass sie bei Verwendung des Speichermediums in einer Steuerung (23) eines Magnetresonanztomographen (1) mit einer Feldkamera (60) nach Anspruch 1 das Verfahren nach einem der Ansprüche 1 bis 7 durchführen.

**Claims**

1. Method for measuring a magnetic field distribution in a spatial volume to be measured, using a magnetic resonance tomograph (1) and a field camera (60) for capturing a magnetic field distribution by means of a magnetic resonance measurement, wherein the field camera (60) has:

   a number of M samples (61), which are distributed over a spatial volume to be measured (70); a number of N receive antennas (62), wherein the receive antennas (62) each have a receive volume (64), in which the magnetic resonance signal produced in the receive antenna by the sample is not attenuated by more than 40 dB relative to a maximum level that can be generated by the sample, and are arranged relative to the spatial volume to be measured (70) in such a way that two of the M samples (61) are arranged in at least one of the receive volumes (64) and the receive volumes (64) are at least partially separate, and at least one sample (61) is arranged in each receive volume (64), wherein the number N of receive antennas (62) is greater than or equal to the number M of samples (61), wherein the method has steps as follows:

   (S100) capturing a sensitivity matrix for the receive antennas (62), with a sensitivity $E_{mn}$ for each sample (61) m at each receive antenna (62) n, using the magnetic resonance tomograph (1);
   (S200) capturing, by means of the N receive antennas (62), N antenna signals $A_n$ of the M samples (61) in a magnetic field to be measured, using the magnetic resonance tomograph (1);
   (S300) determining the M magnetic resonance signals $S_m$ of the individual samples from the N antenna signals $A_n$ as a function of the sensitivity matrix $E_{mn}$, using a controller (23),

   wherein the magnetic resonance tomograph (1) has a gradient system and the field camera (60) is arranged in the magnetic resonance tomograph (1),
   **characterised in that**
   the step (S100) of capturing a sensitivity matrix additionally has the substeps:

   (S110) determining a magnetic field gradient, under whose influence each sample (61) is subjected to a different magnetic field;
   (S120) generating the determined field gradient by means of the gradient system during the capture of the sensitivity matrix $E_{mn}$.

2. Method according to claim 1, wherein the method additionally has the steps:

   (S310) defining the inverse matrix $I_{nm}$ to the sensitivity matrix $E_{mn}$;
   (S320) ascertaining the magnetic resonance signals $S_m$ of the individual samples by multiplying the vector $A_N$ from the N antenna signals with the inverse matrix $I_{nm}$.

3. Method according to claim 1, wherein the step (S100) of capturing a sensitivity matrix additionally has the substeps: (S130) weighting the antenna signals with a time-dependent window function in order to sharpen a spectral distribution during the capture of the sensitivity matrix.

4. Method according to one of the preceding claims, wherein the N receive antennas (62) of the field camera (60) at least partially surround the outer extent of the spatial volume (70).

5. Method according to one of the preceding claims, wherein at least one sample (61) of the field camera (60) has a first resonant circuit with a resonance at the Larmor frequency, wherein the field camera has a second resonant circuit, wherein the first resonant circuit is inductively coupled to the second resonant circuit, and the second resonant circuit has a larger induction surface than the first resonant circuit.

6. Method according to claim 5, wherein the first resonant circuit has a coil and a capacitor, wherein the capacitor is formed from twisted insulated conductor ends of the coil.

7. Method according to claim 5 or 6, wherein the first resonant circuit has two different resonant frequencies.

8. Computer program product which can be loaded directly into a processor of a programmable controller (23) of a magnetic resonance tomograph (1) with a field camera (60) according to claim 1, with program code means for executing all steps of a method according to one of claims 1 to 7 when the program product is executed on the controller (23).

9. Computer-readable storage medium on which is stored electronically readable control information that is so configured as to perform the method according to one of claims 1 to 7 when the storage medium is used in a controller (23) of a magnetic resonance tomograph (1) with a field camera (60) according to claim 1.

**Revendications**

1. Procédé de mesure d'une répartition du champ magnétique dans un volume d'espace à mesurer comprenant un tomodensitomètre (1) par résonnance magnétique et une caméra (60) à champ de détection d'une répartition du champ magnétique au moyen d'une mesure de résonnance magnétique, dans lequel la caméra (60) à champ a :

un nombre de M prises (61), qui sont répartis sur le volume (70) d'espace à mesurer ;
un nombre de N antennes (62) de réception, dans lequel les antennes (62) de réception ont chacune un volume (64) de réception, dans lequel le signal de résonnance magnétique, provoqué par une prise dans l'antenne de réception, n'est pas amorti de plus de 40 dB par rapport à un signal maximum pouvant être produit par la prise et sont disposées, relativement au volume (70) d'espace à mesurer, de manière à ce que au moins deux des M prises (61) soient disposées dans au moins l'un des volumes (64) de réception et de manière à ce que les volumes (64) de réception soient disjoints au moins en partie et de manière à ce qu'au moins une prise (61) soit disposée dans chaque volume (64) de réception,
dans lequel le nombre N des antennes (62) de réception est supérieur ou égal au nombre M des prises (61),
dans lequel le procédé comporte les stades :

(S100) détection, par le tomodensitomètre (1) par résonnance magnétique, d'une matrice de sensibilité pour les antennes (62) de réception avec une sensibilité $E_{mn}$ pour chaque prise (61) m sur chaque antenne (62) de réception n ;
(S200) détection, par le tomodensitomètre (1) par résonnance magnétique au moyen des N antennes (62) de réception, de N signaux $A_n$ d'entrée des M prises (61) dans un champ magnétique à mesurer ;
(S300) détermination, par une commande (23), des M signaux $S_m$ de résonnance magnétique des diverses prises à partir des N signaux $A_n$ d'antenne en fonction de la matrice $E_{mn}$ de sensibilité,

dans lequel le tomodensitomètre (1) par résonnance magnétique a un système de gradient et la caméra (60) à champ est disposée dans le tomodensitomètre (1) par résonnance magnétique,
**caractérisé en ce que**
le stade (S100) de la détection d'une matrice de sensibilité comporte en outre des sous-stades :

(S110) détermination d'un gradient de champ magnétique sous l'effet duquel chaque prise (61) est soumise à un champ magnétique différent ;
(S120) production du gradient de champ déterminé au moyen du système de gradient pendant la détection de la matrice $E_{mn}$

de sensibilité.

2. Procédé suivant la revendication 1, dans lequel le procédé comporte en outre le stade :

(S310) détermination de la matrice $I_{nm}$ inverse de la matrice $E_{mn}$ de sensibilité ;
(S320) détermination des signaux $S_m$ de résonnance magnétique des diverses prises par multiplication d'un vecteur $A_N$ composé des N signaux d'antenne par la matrice $I_{nm}$ inverse.

3. Procédé suivant la revendication 1, dans lequel le stade (S100) de la détection d'une matrice de sensibilité comporte en outre les sous-stades :
(S130) pondération des signaux d'antenne, par une fonction de fenêtre en fonction du temps, pour affiner une répartition spectrale pendant la détection de la matrice de sensibilité.

4. Procédé suivant l'une des revendications précédentes, dans lequel les N antennes (62) de réception de la caméra (60) à champ entourent le volume (70) d'espace au moins en partie en en faisant le tour à l'extérieur.

5. Procédé suivant l'une des revendications précédentes, dans lequel au moins une prise (61) de la caméra (60) à champ a un premier circuit de résonnance ayant une résonnance à la fréquence de Larmor, dans lequel la caméra à champ a un deuxième circuit de résonnance, dans lequel le premier circuit de résonnance est en couplage inductif avec le deuxième circuit de résonnance et le deuxième circuit de résonnance a une surface d'induction plus grande que le premier circuit de résonnance.

6. Procédé suivant la revendication 5, dans lequel le premier circuit de résonnance a une bobine et une capacité, dans lequel la capacité est formée d'extrémités de conducteur isolées torsadées de la bobine.

7. Procédé suivant la revendication 5 ou 6, dans lequel le premier circuit de résonnance a deux fréquences de résonnance différentes.

8. Produit de programme d'ordinateur, qui peut être chargé directement dans un processeur d'une commande (23) programmable d'un tomodensitomètre (1) par résonnance magnétique ayant une caméra (60) de champ suivant la revendication 1, comprenant des moyens de code de programme, pour exécuter tous les stades d'un procédé suivant l'une des revendications 1 à 7, lorsque le produit de programme est exécuté sur la commande (23).

9. Support de mémoire, déchiffrable par ordinateur, ayant des informations de commande, déchiffrables électroniquement, qui y sont mises en mémoire et qui sont conformées de manière à ce qu'elles exécutent, lors de l'utilisation du support de mémoire dans une commande (23) d'un tomodensitomètre (1) par résonnance magnétique ayant une caméra (60) de champ suivant la revendication 1, le procédé suivant l'une des revendications 1 à 7.

FIG 1

FIG 2

61

70

61

63

x

y

z

FIG 3

60

62

62

62

64

70

# FIG 4

S100

S110

S120

S130

S200

S300

S310

S320

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102014213413

**In der Beschreibung aufgeführte Nicht-Patentliteratur**

- **YING-HUA CHU et al.** Decoupled dynamic magnetic field measurements improves diffusion-weighted magnetic resonance images. *SCIENTIFIC REPORTS*, 14 September 2017, vol. 7 (1)

- **YING-HUA CHU et al.** Accurate dynamic magnetic field monitoring and diffusion-weighted image reconstruction using uncorrelated local field measurements. *PROCEEDINGS OF THE INTERNATIONAL SOCIETY FOR MAGNETIC RESONANCE IN MEDICINE, ISMRM, 25TH ANNUAL MEETING AND EXHIBITION, HONOLULU, HI, USA*, 07 April 2017 (3915)